**Europäisches Patentamt**

**European Patent Office**

**Office européen des brevets**

(19)

(11) Veröffentlichungsnummer : **0 620 930 B1**

(12)

# EUROPÄISCHE PATENTSCHRIFT

(45) Veröffentlichungstag der Patentschrift :
**14.06.95 Patentblatt 95/24**

(51) Int. Cl.$^6$ : **G03F 7/16,** B05C 5/00

(21) Anmeldenummer : **93901735.6**

(22) Anmeldetag : **04.01.93**

(86) Internationale Anmeldenummer :
**PCT/EP93/00004**

(87) Internationale Veröffentlichungsnummer :
**WO 93/14444 22.07.93 Gazette 93/18**

(54) **VERFAHREN UND VORRICHTUNG ZUR BESCHICHTUNG VON LEITERPLATTEN.**

(30) Priorität : **07.01.92 DE 4200149**
**08.02.92 DE 9201546 U**

(43) Veröffentlichungstag der Anmeldung :
**26.10.94 Patentblatt 94/43**

(45) Bekanntmachung des Hinweises auf die
Patenterteilung :
**14.06.95 Patentblatt 95/24**

(84) Benannte Vertragsstaaten :
**AT CH DE FR GB IT LI NL**

(56) Entgegenhaltungen :
**EP-A- 0 002 040**
**DE-U- 9 201 546**
**US-A- 3 496 699**
**US-A- 4 791 004**

(73) Patentinhaber : **RÜTGERSWERKE**
**AKTIENGESELLSCHAFT**
**Mainzer Landstrasse 217**
**D-60326 Frankfurt (DE)**
Patentinhaber : **Schäfer, Hans-Jürgen,**
**Dipl.-Ing.**
**Ritterstrasse 36**
**D-41749 Viersen (DE)**

(72) Erfinder : **SCHÄFER, Hans-Jürgen**
**Ritterstrasse 36**
**D-4060 Viersen 12 (DE)**

EP 0 620 930 B1

Jouve, 18, rue Saint-Denis, 75001 PARIS

## Beschreibung

Der vorliegenden Erfindung liegt die Aufgabe zu Grunde, ein verbessertes Verfahren und eine Vorrichtung verfügbar zu machen, die es ermöglichen, im Vorhanggießverfahren Leiterplatten mit fotopolymerisierbaren Lacken zu beschichten.

Das Vorhanggießverfahren ist in der Patentschrift US-PS 4 230 793 beschrieben. Zur Erzielung gleichmäßiger Lackschichten ist es erforderlich, eine möglichst niedrige Lackviskosität zu haben. Diese niedrige Viskosität führt jedoch dazu, daß der Lack von den Leiterkanten abläuft (Kantenflucht), und somit eine ungenügende Kantenabdeckung erzielt wird.

Dieses Problem ist in der EP-A 0 075 537 beschrieben und durch Zugabe von feinteiligem Füllstoff gelöst. Die erforderliche Viskosität von 380 mPa·s wird durch Zugabe von Lösemitteln erst bei einem Festkörpergehalt von 33 bis 40 % erreicht.

Die hohen Lösemittelanteile machen eine sehr langsame und aufwendige Trocknung erforderlich. Es besteht insbesondere bei engen und hohen Leitern die Gefahr von Luftblasen und Lösemitteleinschlüssen.

Es ist daher Aufgabe der Erfindung, eine umweltfreundliche Möglichkeit zur Beschichtung von Leiterplatten bereitzustellen, die vorzugsweise im Vorhanggießverfahren angewendet wird, die mit möglichst wenig oder sogar ohne Lösemittel durchgeführt werden kann und bei der selbst bei hohen und engen Leitern der Einschluß von Luftblasen und Lösemittelresten minimiert ist.

Es ist ferner Aufgabe der Erfindung, eine möglichst gleichmäßige Beschichtung mit einer nur minimalen Kantenflucht zu erzielen.

Die Lösung der Aufgabe erfolgt durch ein Verfahren gemäß der Ansprüche 1 bis 4 und durch eine Vorrichtung zur Durchführung des Verfahrens gemäß der Ansprüche 5 bis 11.

Gegenstand der vorliegenden Erfindung ist daher ein Verfahren, welches von einem lösemittel-armen oder lösemittelfreiem fotopolymerisierbaren Lack ausgeht, dessen Viskosität durch kurzzeitiges Erhitzen in einer erfindungsgemäßen Vorrichtung herabgesetzt wird und der dann in Form eines aufgeheizten Lackvorhangs auf eine gekühlte Leiterplatte trifft, die durch diesen hindurchgeschossen wird.

Beim erfindungsgemäßen Verfahren werden fotopolymerisierbare, lösemittel-arme bis -freie Lacksysteme mit einem Feststoffanteil von 80 bis 100 Gew.-%, bevorzugt von 85 bis 95 Gew.-% mit einer beheizbaren Walze aus einer auf 60 bis 80 °C temperierten Wanne geschöpft und über eine beheizte Rakel bei Temperaturen von 60 bis 90 °C, vorzugsweise bei 70 bis 80 °C entgast und durch Infrarotstrahler kurzfristig erhitzt und zum Fließen gebracht.

Im laufenden Prozeß entsteht durch das Abfließen des auf 100 bis 160 °C erhitzten Lacksystems, der eine Viskosität von 100 bis 500 mPa·s, bevorzugt von 100 bis 180 mPa·s hat von einer Schrägrakel, ein Flüssigkeitsvorhang, durch den die Leitplatten mit einer Geschwindigkeit von bevorzugt 150 bis 300 m/min hindurchbewegt und dabei beschichtet werden. Es werden dabei Lackschichten mit einer Dicke von 5 bis 30 μm erreicht.

Erfindungsgemäß sind die zu beschichtenden Leiterplatten nicht erwärmt sondern vielmehr auf eine Temperatur im Bereich von -20 bis +25 °C, bevorzugt von -10 bis +10 °C gekühlt.

Die erfindungsgemäß eingesetzten Lacke haben bei 20 °C eine Viskosität von 10 000 bis 150 000 mPa·s. Da sie keine oder nur geringe Mengen an Lösemitteln enthalten können, sind zur Viskositätseinstellung keine Füllstoffe notwendig. Allenfalls aus wirtschaftlichen Gründen kann das Lacksystem bis zu 50 Gew.-%, bevorzugt bis zu 10 Gew.-% feinteilige, an sich bekannte Füllstoffe enthalten.

Die bevorzugten Bindemittel für die fotohärtenden Lacke sind solche, die sowohl fotohärtende, ungesättigte Gruppen enthalten als auch thermisch vernetzbare, wie etwa Epoxidgruppen. Dadurch wird es ermöglicht, die beschichteten Platten durch Strahlung vorzuvernetzen und nachfolgend durch thermische Behandlung eine Endhärtung zu erreichen. Derartige Bindemittel sind z. B. aus EP-B 0 194 360 bekannt.

Die erfindungsgemäße Vorrichtung für die Beschichtung von Leiterplatten ist eine Beschichtungsmaschine bei der in einer Beschichtungsanlage für das Vorhanggießverfahren oberhalb des Transportbandes (7) für die Leiterplatten eine beheizbare Walze (3) in einer rinnenförmigen, beheizbaren Wanne (2) angeordnet ist, daß an die Walze eine beheizbare Rakel (4) angebracht ist, über dem parallel zur Rakel Infrarotstrahler (5) angebracht sind.

Die beheizbare Walze hat einen Durchmesser von etwa 10 bis 30 cm und die rinnenförmige Wanne einen etwa 2 bis 5 cm größeren Durchmesser. Die beheizbare Rakel ist abwärts geneigt angeordnet und etwa 30 bis 70 cm lang und dient als Abflußblech, bei dem der Lack in dünner Schicht entgast und aufgeheizt werden kann. Zusätzlich zu dieser Rakel ist an die Walze noch mindestens eine Abstreifrakel (15) angebracht, die breiten - und/oder dickenverstellbar ist. Der beheizbaren Wanne vorgeschaltet sind ein kühlbarer Vorratsbehälter (8) und eine Dosiervorrichtung (9). Der Vorratsbehälter dient gleichzeitig als Auffangbehälter für den, von der Rakel abgeflossenen, nicht für Beschichtungen verbrauchten Lack.

In der bevorzugten Ausführung ist am Ende der beheizbaren Rakel senkrecht mindestens ein Infrarotstrahler (10) angeordnet, mit dem die Temperatur des fließenden Lackvorhangs gesteuert werden kann.

Dem Transportband für die Leiterplatten ist ein Kühlspeicher (6) vorgeschaltet, der die Leiterplatten auf die gewünschte Temperatur kühlt.

Bei Betrieb der erfindungsgemäßen Vorrichtung schöpft die beheizbare Walze (3) aus einer temperierten, rinnenförmigen Lackwanne (2) Lack. Dieser Lackfilm wird mit einer beheizten Rakel (4) von der Walze abgenommen. Über der Rakel ist ein infrarotstrahler (5) angebracht, der mittig aufgehängt ist. Durch geeignete Halterungen, insbesondere durch Schrägstellung läßt sich so ein variabler Strahlerabstand einstellen, der am Rakelanfang am geringsten ist. Die Strahlungstemperatur wird mit 160 bis 220 °C so eingestellt, daß eine gute IR-Absorption des Lackes gewährleistet ist. Dieser wird nun bei einer Fließgeschwindigkeit von 2 bis 4 l/min in 1 bis 2 sek. auf 100 bis 160 °C erwärmt, ohne daß er überhitzt wird. Durch die erfindungsgemäße Anordnung des Strahlers und der mit einer verchromten Oberfläche versehenen Rakel ist es möglich, den Lackfilm gezielt aufzuheizen. Da diese von einem flüssigen Medium durchflossen wird, sorgt dieses bei Überhitzung des Films für deren Kühlung.

Je nach Einstellung der Infrarotstrahler kann es, insbesondere bei reaktiven Lacken, vorteilhaft sein, die Temperatur des Lackes erst während des Falles von der Rakelkante auf die Leiterplatte noch zu erhöhen. dies erfolgt durch mindestens einen weiteren, am Ende der beheizbaren Rakel senkrecht, d. h., parallel zum Vorhang angebrachten Infrarotstrahler (10).

Da es sich bei fotopolymerisierbaren Lacken um thermisch sehr instabile Verbindungen handelt, ist bei ihrer Verarbeitung nur eine kurzzeitige Erhitzung erlaubt. Mit der erfindungsgemäßen Vorrichtung ist es erstmals möglich, den Lack schnell auf Gießtemperetur aufzuheizen, ohne die Temperatur zu überschreiten, bei der die Polymerisation einsetzt.

Dieser nach dem IR-Aufschmelzen auf eine Viskosität von 100 bis 500 mPa·s herabgesetzte Lack fließt eine etwa 20 bis 70 cm lange Schrägrakel herunter, und fällt als Vorhang auf die Leiterplatte, die mit einer Geschwindigkeit von 150 bis 300 m/min, bevorzugt mit einer Geschwindigkeit von 250 bis 300 m/min hindurchgeführt wird.

Nach bisherigem Stand der Technik führt eine niedrige Viskosität des Lackes zu einer geringen Kantenabdeckung der Leiterzüge. Dieses Problem wird erfindungsgemäß dadurch gelöst, daß die Leiterplatten nicht wie bisher üblich vor der Beschichtung erwärmt werden.

Es wurde überraschenderweise gefunden, daß nach dem erfindungsgemäßen Verfahren eine Erwärmung nicht erforderlich ist. Es wurde im Gegenteil festgestellt, daß sich eine vorherige Abkühlung der Leiterplatten positiv auf das Beschichtungsergebnis auswirkt. Die Lackviskosität steigt nach dem Auftreffen auf die Leiterplattenoberfläche schlagartig an, so daß insbesondere durch die gute Wärmeleitfähigkeit der Kupferleiter ein Ablaufen von den Kanten vermieden wird.

Enge Abstände zwischen hohen Leitern können nach dem erfindungsgemäßem Verfahren fehlerfrei beschichtet werden, ohne daß es zu Lösemitteleinschlüssen kommt. Eventuell noch vorhandene Luft und Restlösemittel werden erfindungsgemäß in einem nachgeschalteten IR-Strahlungsofen (11) unter Vakuum entfernt. Dieser evakuierbare IR-Ofen erhitzt die Lackoberfläche, wobei über die gewählte Strahlertemperatur die bevorzugt zwischen 60 bis 180 °C liegt, die Lackviskosität einstellbar ist, bei der eine gute Vakuumentgasung gewährleistet ist. Die vorherige Kühlung der Leiterplatte führt dazu, daß die Strahlung von den Leiterzügen nicht aufgenommen wird. Der Lack an den Leiterflanken wird am geringsten erwärmt und kann daher nicht ablaufen. In den Tälern zwischen den Leitern wird hingegen eine wirksame Vakuumentgasung ermöglicht.

Anschließend werden die Schaltungen in bekannter Weise im off-Kontakt, bzw. soft-Kontaktverfahren mit UV-Licht der Wellenlänge 350 bis 400 nm belichtet, entwickelt und endausgehärtet.

Als Bindemittel können fotopolymerisierbare Harze unterschiedlichen chemischen Aufbaus verwendet werden, wie sie dem Fachmann bekannt sind. Es können lösemittel-arme bis -freie Lacke eingesetzt werden, abhängig vom mittlerem Molekulargewicht des Harzrohstoffes. Gleichzeitig hat das mittlere Molekulargewicht Auswirkungen auf den Erweichungspunkt des physikalisch getrockneten Lackes. Während z. B. ein lösemittelfreier Lack mit einem mittleren Molekulargewicht von 500 nach der Beschichtung vor der Belichtung eine klebrige Lackschicht ergibt, läßt sich mit Bindemitteln, die ein mittleres Molekulargewicht von größer 3 000 haben, ein klebfreier Lackfilm erzeugen. Es wurde nun gefunden, daß das erfindungsgemäße Verfahren durch die Erzeugung eines lösemittelfreien Lackfilms die Möglichkeit eröffnet, durch die Herabsetzung des Molekulargewichts einen höheren Lackfestkörper zu erzielen, ohne daß der Lackfilm vor dem Belichten bei Raumtemperatur klebt. Es lassen sich somit Lacke mit einem Festkörpergehalt von mehr als 80 Gew.-% herstellen, die nach der Beschichtung nicht mehr die bisher üblichen 3 bis 5 % Restlösemittel im Lackfilm enthalten und die somit eine klebfreie Lackschicht ergeben.

Da es erfindungsgemäß nicht erforderlich ist, den Lack, zur Erzielung einer besseren Kantenabdeckung der Leiter mit Füllstoffen zu thixotropieren, kann auf Füllstoffe weitestgehend verzichtet werden. Es wurde außerdem gefunden, daß ein Zusatz von Epoxisilan, wie er zu Faserausrüstung bei GFK-Verbundmaterialien verwendet wird, die Metallhaftung des Lackes deutlich erhöht. Ferner hat sich gezeigt, daß bei lösemittelfreien Lacken im Gegensatz su DE-A 36 13 107 der Zusatz von Reaktivverdünnern nicht höher als 5 % sein sollte, da der Lackfilm sonst an Elastizität verliert und bei der Lötbelastung reißt, bzw. abplatzt.

Für solche Bindemittel, die neben den fotohärtenden, ungesättigten Gruppen noch freie Epoxidgruppen enthalten, hat sich für die thermische Härtung die Gruppe der Phenolnovolake als geeignete Härterkomponente herausgestellt. Es wurde hiermit eine lange Gebrauchsdauer bei 40 bis 50 °C sowie eine hohe Härtungsgeschwindigkeit erzielt.

Die füllstofffreie Lackeinstellung gemäß Beispiel 3 hat in Zusammenhang mit der Härtung von o-Kresolnovolak zu einer Lötstopplackschicht beigetragen, die eine wesentlich geringere Lötperlenaffinität aufweist.

Beispiel 1

Fotopolymerisierbarer Lötstopplack mit einem Festkörper von 85 bis 95 %, Harz A gemäß EP-B 0 194 360 mit einem Molekulargewicht von 1 500 bis 2 000.

```
 80,00 Gew.-Teile     Harz A  85 %
  2,00 Gew.-Teile     Ethylanthrachinon
  0,50 Gew.-Teile     Phthalocyanin grün
  1,00 Gew.-Teil      Epoxisilan Z 6040 (Dow Corning)
  8,00 Gew.-Teile     Bisphenol A-Novolak
  1,00 Gew.-Teil      2-Ethyl-4-methylimidazol
  1,00 Gew.-Teil      Byk®-361 Verlaufsmittel
  0,50 Gew.-Teile     Byk®-055 Entschäumer
  3,00 Gew.-Teile     Bariumsulfat
  3,00 Gew.-Teile     Mikrotalkum
100,00 Gew.-Teile     = 88 Gew.-%
```

Beispiel 2

Fotopolymerisierbarer Lötstopplack mit einem Festkörper von 90 bis 95 %, Harz B gemäß EP-B 0 194 360 mit einem Molekulargewicht von 1 000 bis 1 500.

```
 80,00 Gew.-Teile     Harz B  Festkörper  90 %
  2,00 Gew.-Teile     Ethylanthrachinon
  0,50 Gew.-Teile     Phthalocyanin grün
  1,00 Gew.-Teil      Epoxisilan Z 6040 (Dow Corning)
  9,00 Gew.-Teile     Polyhydroxystyrol (80 %)
  1,00 Gew.-Teile     2-Ethyl-4-methylimidazol
  0,50 Gew.-Teile     Byk®-361 Verlaufsmittel
  0,50 Gew.-Teile     Byk®-055 Entschäumer
  2,50 Gew.-Teile     Bariumsulfat
  3,00 Gew.-Teile     Mirkotalkum
100,00 Gew.-Teile     = 93 Gew.-%
```

### Beispiel 3

Fotopolymerisierbarer Lötstopplack mit einem Festkörper von 95 bis 100 %, Harz C gemäß EP-B 0 194 360 mit einem Molekulargewicht von 500 bis 700.

```
  80,00 Gew.-Teile     Harz C Festkörper 100 %
   4,00 Gew.-Teile     Triethylpropantriacrylat
   2,00 Gew.-Teile     Ethylanthrachinon
   0,30 Gew.-Teile     Epoxisilan Z 6040 (Dow Corning)
   0,50 Gew.-Teile     Phthalocyanin grün
  11,50 Gew.-Teile     o-Kresolnovolak
   1,00 Gew.-Teil      2-Ethyl-4-methylimidazol
   0,30 Gew.-Teile     Byk®-361 Verlaufsmittel
   0,40 Gew.-Teile     Byk®-055 Entschäumer
 100,00 Gew.-Teile     = 99 Gew.-%
```

Die Lackmischungen gemäß der Beispiele 1 bis 3 werden zur Durchführung des erfindungsgemäßen Beschichtungsverfahrens in die erfindungsgemäße Vorrichtung gegeben. Hier werden sie in einem Lackvorratsbehälter auf ca. 30 bis 50 °C aufgewärmt, die Viskosität beträgt ca. 1 000 bis 5 000 mPa·s. Mit dieser Viskosität werden sie in die beheizte Lackwanne (2) gepumpt, deren Wandung auf 70 °C aufgewärmt ist. In dieser Lackwanne (2), die zwecks optimaler Lackverteilung V-förmig mit einem Winkel von 60 ° ausgebildet ist, wird der Lack von unten über eine schlitzförmige Bodenöffnung hineingepumpt. In dieser Wanne (2) ist eine beheizte Walze (3) so angeordnet, daß der Abstand zum äußersten Wannenrand auf 0 gefahren werden kann. Somit kann durch ein definierte Spalteinstellung die Mitnahme von Lack gezielt eingestellt werden. Die beheizte Walze (3) hat eine Temperatur von 80 °C.

Der Lack wird von der Walze aufgenommen und auf eine beheizte Schrägrakel (4) übertragen. Die Walze (3) und die Rakel (4) haben verchromte Oberflächen und werden von flüssigen Heizmedien durchströmt. Die Rakel (4) hat eine Temperatur von 80 °C.

Zum schnellen Aufheizen des Lackfilms ist über der Rackel (4) ein Infrarotstrahler (5) angebracht. Es hat sich herausgestellt, daß eine Strahlertemperatur von 160 bis 220 °C eine gute IR-Absorption des Lackes gewährleistet. Der Lack fließt nun durch die Viskositätserniedrigung die Schrägrakel (4) herunter und fällt in Form eines Vorhangs auf die Leiterplatten, die mit einer Geschwindigkeit von 150 bis 300 m/min hindurchbewegt werden. Diese Leiterplatten werden vor der Beschichtung in einer Bimsmehlbürstanlage gereinigt und entgegen der bisherigen Praxis nicht erwärmt, sondern durch einen Kühlspeicher (6) auf +25 °C bis -20 °C, bevorzugt auf +10 °C bis -10 °C gekühlt. Anschließend gelangt diese Platte in den geschlossenen Beschichtungsraum (1) der mit Inertgas gefüllt ist. Nach dem Verlassen des Beschichtungsraumes wird die beschichtete Leiterplatte in einen evakuierbaren Strahlungsofen (11) transportiert.

In diesem Strahlungsofen (11) werden restliche Lösemittel- und Lufteinschlüsse entfernt. Die lösemittelfreie und luftblasenfreie Lackschicht kann nun je nach ihrem Zustand (klebrig oder klebfrei) im off-Kontaktverfahren oder im soft-Kontaktverfahren im UV-Licht bei einer Wellenlänge von 350 bis 400 nm belichtet werden. Die Entwicklung ist vom Lacksystem abhängig und kann in an sich bekannter Weise mit Lösemitteln oder wäßrig-alkalisch erfolgen.

Der überschüssige Lack wird mit einer Kühlwalze (12) wieder auf Verfahrenstemperatur von 30 bis 50 °C heruntergekühlt und in das Vorratsgefäß zurückgeleitet.

Neben Lötstopplacken lassen sich bevorzugt auch lösemittelfreie Ätzresiste auftragen. Hiermit lassen sich die Bohrungen der Leiterplatten überdecken. Es wird hierdurch ein Ersatz der Festresistfolien erreicht. Die besondere Flexibilität durch die verlustfreie und dickenvariable Auftragstechnik führt zu erheblichen Kosteneinsparungen.

### Beispiel 4

Fotopolymerisierbarer Ätzresist mit einem Festkörper von 95 bis 100 %; Harz C gemäß EP-B 0 194 360 mit einem Molekulargewicht von 500 bis 700.

```
   94,50 Gew.-Teile      Harz C   100 %
    3,00 Gew.-Teile      Ethylanthrachinon
    1,50 Gew.-Teile      Byk®-361 Verlaufsmittel
    0,50 Gew.-Teile      Byk®-055 Entschäumer
    0,50 Gew.-Teile      Savinylblau
  100,00 Gew.-Teile      = 99 Gew.-%
```

Dieser Ätz- und Galvanoresist ist mit Lösemitteln entwickelbar und alkalisch strippbar.

Da lösemittelfreie Lacke keinen klebfreien Lackfilm vor dem Belichten ergeben und somit im off-Kontaktverfahren belichtet werden müssen, kann nur eine Seite belichtet werden, was zu einer erheblichen Kapazitätseinbuße führt. Andererseits ist es für die Feinstleitertechnologie nötig, mit sogenanntem kaltem UV-Licht bei 20 bis 23 °C zu belichten, um eine höchstmögliche Reproduzierbarkeit zu erreichen. Während übliche UV-Belichter noch einen hohen Infrarotanteil haben, der trotz intensiver Kühlung das Substrat auf 40 bis 50 °C aufwärmt.

Es hat sich überraschenderweise herausgestellt, daß mit einem Belichter mit kaltem UV-Licht bei aus Lösung applizierten Resisten ungewöhnlich lange Belichtungszeiten erforderlich waren. Bei der Untersuchung dieses Phänomens hat sich herausgestellt, daß die nach der Trocknung noch verbliebenen Lösemittelanteile von 3 bis 5 % als Inhibitor die UV-Härtung verzögern, bzw. völlig behindern. Diese Restlösemittel werden bei den bisher üblichen Belichtern durch den IR-Anteil im UV-Licht offensichtlich soweit entfernt, daß die Härtung nicht mehr behindert wird. Daher wird zur Erzielung höchster Präzision in der Feinstleitertechnik insbesondere bei Multilayerinnenlagen das sogenannte Accutraceverfahren eingesetzt. Hier wird ein lösemittelfreier Lack mit einem Rollercoater appliziert und dann im off-Kontaktverfahren belichtet. Der Nachteil dieses Verfahrens liegt in der off-Kontaktbelichtung, die nur die Hälfte der Kapazität ermöglicht, sowie in der Tatsache, daß sogenannte "via holes" nicht mehr überdeckt werden können. Für aus Lösung applizierte Lacke besteht ebenfalls das Problem der "via holes", die nicht überdeckt werden können, damit die Lochwandungen beim Ätzen geschützt sind.

Mit dem erfindungsgemäßen Verfahren ist es möglich, diese Probleme zu lösen. Während mit einer Lackrezeptur gemäß Beispiel 4 eine Lochüberdeckung bis 1,5 mm möglich ist, kann mit einer festkörperreichen sogen. "high solid" Lackmischung eine klebfreie Beschichtung erreicht werden, die eine beidseitige Belichtung im Kontaktverfahren ermöglicht, wobei durch die Lösemittelfreiheit des Lackfilms eine Härtung im kalten UV-Licht gewährleistet ist.

Beispiel 5

Fotopolymerisierbarer Ätzresist mit einem Festkörper von 80 bis 85 %, Harz E gemäß EP-B 0 194 360 mit einem Molekulargewicht von 2 000 bis 2 500.

```
   88,00 Gew.-Teile      Harz E    80 %
    7,00 Gew.-Teile      MgO
    3,00 Gew.-Teile      Ethylanthrachinon
    1,00 Gew.-Teil       Byk®-361 Verlaufsmittel
    0,50 Gew.-Teile      Byk®-055 Entschäumer
    0,50 Gew.-Teile      Savinylblau
  100,00 Gew.-Teile      = 82 Gew.-%
```

Der Ätzresist gemäß Beispiel 5 wird mit der erfindungsgemäßen Vorrichtung aufgebracht und das Restlösemittel im Vakuumofen entfernt. Als besonders nachteilig ist bislang, daß es mit der Vorhangbeschichtung nicht möglich ist, eine Schichtdicke von 60 μm zu unterschreiten. Dies ist einerseits auf die minimalste Vorhangdicke zurückzuführen, die aus Stabilitätsgründen nicht unterschritten werden kann, andererseits kann die Beschichtungsgeschwindigkeit nicht über 200 m/min erhöht werden, ohne daß die auf einem Transportband Liegenden Leiterplatten beim Auftreffen auf den Lackvorhang springen und eine gleichmäßige Beschichtung somit nicht möglich ist. Es wurde nun gefunden, daß mit Beschichtungsgeschwindigkeiten von 250 bis 300 m/min Lackschichten von 5 bis 30 μm erzielbar sind. Hierzu wird eine erfindungsgemäße Vorrichtung benutzt, die als Beschichtungsschlitten bezeichnet werden kann.

Die Innenlagen von Mehrlagenleiterplatten werden mit Vakuumsaugern am Rand gehalten. Diese Vakuumsauger sind auf je zwei mit einem Kniegelenk ausgestatteten Halterungen montiert, die ihrerseits auf Schienen geführt werden, die außerhalb des Lackvorhangs installiert sind. Die so befestigte Leiterplatte oder Innenlage von Mehrlagenleiterplatten kann nun mit hoher Geschwindigkeit unter dem Vorhang hindurch bewegt werden, ohne daß es zu Beschichtungsstörungen kommt. Dieser Beschichtungsschlitten kann auch außer in 90 ° zum Vorhang in 70 ° oder 110 ° geführt werden, wobei hier bestimmte Beschichtungseffkte erzielt werden können. Die so erzielten Ätzresistschichten von 5 bis 30 μm sind nach der Trocknung im Vakuumofen klebfrei und lassen sich beidseitig im Kontaktverfahren im kalten UV-Licht bei einer Wellenlänge von 300 bis 450 nm belichten. Die Entwicklung erfolgt in Lösemitteln, wobei sich Butyldiglykol als besonders geeignet herausgestellt hat. Nach dem Ätzen in sauren bis schwach alkalischen Ätzlösungen, wird alkalisch bei pH 10 bis 14 gestrippt.

Dieses Verfahren macht es erstmalig möglich, die Vorteile der Flüssigresistbeschichtung (hohe Bildauflösung, gute Haftung) zu nutzen, ohne auf die bisher nur von den Festresistfolien erfüllten Forderungen der Lochüberdeckung verzichten zu müssen.

Bei der beidseitigen Beschichtung und Belichtung ist es insbesondere wichtig, die Leiterplatte vor der zweiten Beschichtung zu kühlen und die bereits beschichtete Seite beim Trocknen im Vakuumstrahlungsofen klebfrei zu halten. Außerdem soll eine Erwärmung der Leiterplatte vor der Belichtung auf über 25 °C vermieden werden.

Dies wird erfindunggemäß dadurch gelöst, daß der Boden des Vakuumstrahlungsofens mit einer verchromten Kühlplatte (14) ausgestattet ist, die ein Aufwärmen der Leiterplatte während der IR-Strahlungseinwirkung sowie ein Kleben der ersten Lackschicht verhindert.

Beispiel 6 (Verfahrensbeispiel)

| Lackrezeptur | fotopolym. Lötstopplack Beispiel 3 | fotopolym. Ätzresist Beispiel 5 |
|---|---|---|
| Viskosität mPa·s 20 °C | 150 000 | 80 000 |
| Gießtemperatur °C | 80 | 70 |
| Gießviskosität mPa·s | 150 | 170 |
| Fließgeschwindigkeit l/min | 3 | 3 |
| Leiterplattentemperatur °C | -10 | +15 |
| Beschichtungsgeschwindigkeit | 180 m/min | 250 m/min |
| Lackauftrag g/m² | 80 | 25 |
| Rakel/Walzentemperatur °C | 80 | 80 |
| Strahlertemperatur °C | 180 | 180 |
| Kühlwalzentemperatur °C | +10 | +10 |
| Strahler Vakuumofen °C | 130 | 130 |
| Vakuumzeit | 20 | 40 |
| Kühlplatte °C | +10 | +10 |
| Lackoberfläche bei 20 °C | klebrig | trocken |
| Belichtung (390 nm) | 20 | 10 |
| Belichtungsart | off-Kontakt | Kontakt |
| Entwicklung in Butyldiglykol | 60 | 60 |
| Aushärtung bei 150 °C (min) | 60 | --- |

Meßergebnisse:

| | | |
|---|---|---|
| Leiterzughöhe μm | 80 | --- |
| Leiterzugbreite μm | 100 | --- |
| Kantenabdeckung | 57 % | --- |
| Restlösungsmittel % | 0 | 0,01 |
| Lötbad bei 290 °C | 90 | --- |
| Auflösung/Ätzkeil μm | --- | 20 |

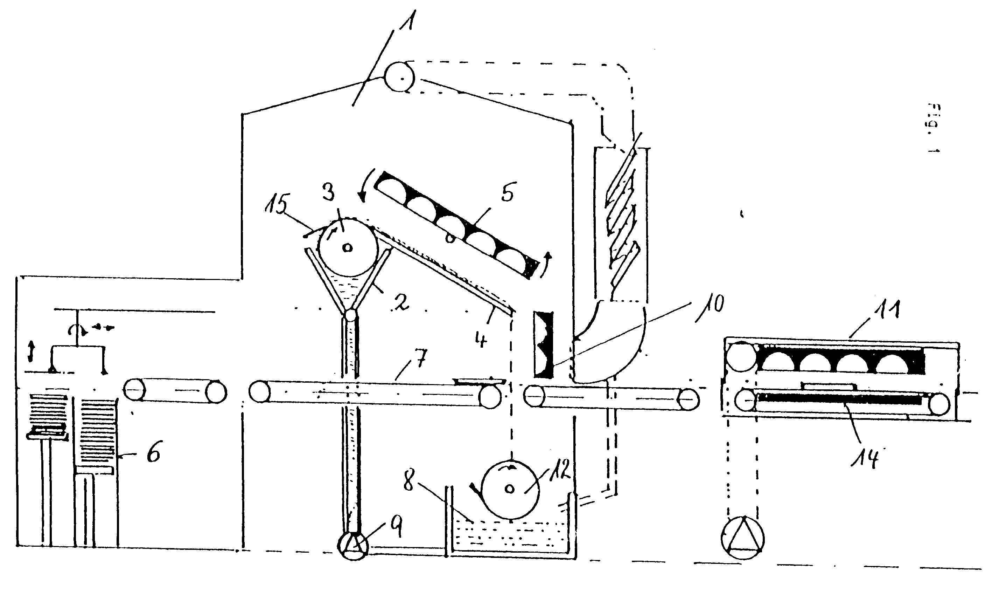

**Patentansprüche**

1. Verfahren zur Beschichtung von Leiterplatten mit fotopolymerisierbaren Lacken im Vorhanggießverfahren, **dadurch gekennzeichnet,** daß ein Lacksystem mit hohem Feststoffanteil von 80 bis 100 Gew.-%,

mittels einer beheizbaren Walze (3) aus einer temperierten Wanne (2) von 40 bis 60 °C entnommen und auf eine auf 60 bis 90 °C beheizte Rakel (4) aufgebracht, durch Infrarotstrahler (5) zum Fließen gebracht, und anschließend mit einer Viskosität von 100 bis 500 mPa·s auf gekühlte Leiterplatten von -20 bis +25 °C gegossen wird.

2. Verfahren nach Anspruch 1, **dadurch gekennzeichnet,** daß fotopolymerisierbare Lacke mit einer Viskosität von 10 000 bis 150 000 mPa·s bei 20 °C eingesetzt werden, die vorzugsweise 0 bis 10 Gew.-%, maximal jedoch 50 Gew.-% Füllstoffe, bezogen auf das Harzsystem, enthalten.

3. Verfahren nach den Ansprüchen 1 und 2, **dadurch gekennzeichnet,** daß Leiterplatten zur Erzielung von Lackschichten im Bereich von 5 bis 30 μm mit einem Beschichtungsschlitten unter dem Lackvorhang mit einer Geschwindigkeit von 250 bis 300 m/min hindurch bewegt werden.

4. Verfahren nach den Ansprüchen 1 bis 3, **dadurch gekennzeichnet,** daß der überschüssige Lack mit einer Kühlwalze (12) auf eine Verfahrenstemperatur von 30 bis 50 °C heruntergekühlt wird.

5. Vorrichtung zur Beschichtung von Leiterplatten mit fotopolymerisierbaren Lacken im Vorhanggießverfahren, **dadurch gekennzeichnet,** daß in einer Beschichtungsanlage für das Vorhanggießverfahren oberhalb des Transportbandes für die Leiterplatten (7) eine beheizbare Walze (3) in einer rinnenförmigen, beheizbaren Wanne (2) angeordnet ist, daß an die Walze (3) eine beheizbare Rakel (4) angebracht ist, über der parallel zur Rakel (4) Infrarotstrahler (5) angebracht sind.

6. Vorrichtung nach Anspruch 5, **dadurch gekennzeichnet,** daß auf der beheizbaren Walze (3) mindestens eine zusätzliche breitenverstellbare Abstreifrakel (15) angebracht ist.

7. Vorrichtung nach den Ansprüchen 5 und 6, **dadurch gekennzeichnet,** daß dem Transportband für die Leiterplatten (7) ein Kühlspeicher (6) vorgeschaltet ist.

8. Vorrichtung nach den Ansprüchen 5 bis 7, **dadurch gekennzeichnet,** daß am Ende der beheizbaren Rakel (4) senkrecht mindestens ein Infrarotstrahler (10) installiert ist.

9. Vorrichtung nach den Ansprüchen 5 bis 8, **dadurch gekennzeichnet,** daß der beheizbaren Wanne (2) ein kühlbarer Vorratsbehälter (8) und eine Dosiervorrichtung (9) vorgeschaltet sind.

10. Vorrichtung nach den Ansprüchen 5 bis 9, **dadurch gekennzeichnet,** daß die Infrarotstrahler (5, 10) im Temperaturbereich von 160 bis 220 °C betreibbar sind und daß durch geeignete Halterungen ein variabler Strahlerabstand ermöglicht wird.

11. Vorrichtung nach Anspruch 5, **dadurch gekennzeichnet,** daß sie einen Beschichtungsschlitten besitzt, der Vakuumsauger besitzt, die auf je zwei mit einem Kniegelenk ausgestatteten Halterungen montiert sind und die ihrerseits auf Schienen geführt werden, die außerhalb des Lackvorhangs installiert sind.

## Claims

1. A method of coating printed circuit boards with photopolymerizable lacquers in the curtain-casting process, **characterized in that** a lacquer system with a high proportion of solids of from 80 to 100% by weight is removed by means of a heated roller (3) from a tempered trough (2) at 40 to 60°C and is supplied to a doctor blade (4) heated to 60 to 90°C, is made to flow by infrared radiators, and is then poured at a viscosity of 100 to 500 mPa·s onto printed circuit boards cooled from -20 to +25°C.

2. A method according to Claim 1, **characterized in that** photopolymerizable lacquers with a viscosity of 10,000 to 150,000 mPa·s are introduced at 20°C, and preferably contain 0 to 10% by weight, and at most 50% by weight, of fillers, relative to the resin system.

3. A method according to Claims 1 and 2, **characterized in that** printed circuit boards are moved through under the lacquer curtain by a coating slide at a speed of 250 to 300 m/min in order to obtain lacquer coatings in the range of 5 to 30 μm.

4. A method according to Claims 1 to 3, **characterized in that** the excess lacquer is cooled down to a method temperature of 30 to 50°C by a cooling roller (12).

5. A device for coating printed circuit boards with photopolymerizable lacquers in the curtain-casting process, **characterized in that** in a coating plant for the curtain-casting process, above the conveyor belt for the printed circuit boards (7), a heatable roller (3) is arranged in a channel-shaped heatable trough (2), [and] a heatable doctor blade (4) is mounted on the roller (3), above which infrared radiators (5) are arranged parallel to the doctor blade (4).

6. A device according to Claim 5, **characterized in that** at least one additional wiper blade (15) of adjustable width is mounted on the heatable roller (3).

7. A device according to Claims 5 and 6, **characterized in that** a cooling reservoir (6) is arranged upstream of the conveyor belt for the printed circuit boards (7).

8. A device according to Claims 5 to 7, **characterized in that** at least one infrared radiator (10) is installed vertically at the end of the heatable doctor blade (4).

9. A device according to Claims 5 to 8, **characterized in that** a coolable storage tank (8) and a metering device (9) are arranged upstream of the heatable trough (2).

10. A device according to Claims 5 to 9, **characterized in that** the infrared radiators (5, 10) can be operated in the temperature range of 160 to 220°C, and a variable radiator distance is made possible by suitable retaining means.

11. A device according to Claim 5, **characterized in that** it comprises a coating slide comprising vacuum suckers which are each mounted on two retaining means provided with a toggle joint and which in turn are guided on rails installed outside the lacquer curtain.

## Revendications

1. Procédé pour l'enduction de cartes imprimées à l'aide de vernis photopolymérisables dans le procédé à rideau fondu, caractérisé en ce qu'un système de vernis avec un taux de solides élevé de 80 à 100% en poids est prélevé au moyen d'un cylindre chauffant (3) dans une cuve (2) maintenue à une température de 40 à 60°C et est amené sur une racle (4) chauffée à une température de 60 à 90°C, est fluidifié à l'aide de radiateurs infrarouges (5) et ensuite coulé à une viscosité de 100 à 500 mPa.s sur des cartes de circuits imprimés refroidies de -20 à +25°C.

2. Procédé selon la revendication 1, caractérisé en ce qu'on met en oeuvre des vernis photopolymérisables d'une viscosité de 10 000 à 150 000 mPa.s à 20°C qui contiennent de préférence 0 à 10% en poids, toutefois au maximum 50% en poids de matières de charge par rapport au système de vernis.

3. Procédé selon les revendications 1 et 2, caractérisé en ce que, pour l'obtention de couches de vernis dans la gamme de 5 à 30 μm, les cartes imprimées sont déplacées à l'aide d'un chariot d'enduction sous le rideau de vernis à une vitesse de 250 à 300 m/min.

4. Procédé selon les revendications 1 à 3, caractérisé en ce que le vernis excédentaire est refroidi avec un tambour refroidisseur (12) jusqu'à une température d'exploitation de 30 à 50°C.

5. Dispositif pour l'enduction de cartes imprimées à l'aide de vernis photopolymérisables dans le procédé à rideau fondu, caractérisé en ce que, dans une installation d'enduction pour le procédé à rideau fondu, un cylindre chauffant (3) est placé dans une cuve chauffante (2) en forme de goulotte au-dessus de la bande transporteuse (7) pour les cartes imprimées et qu'une racle chauffante (4) est montée sur le cylindre (3) au-dessus de laquelle des radiateurs infrarouges (5) sont disposés parallèlement à la racle (4).

6. Dispositif selon la revendication 5, caractérisé en ce qu'au moins une raclette supplémentaire déplaçable en largeur (15) est montée sur le cylindre chauffant (3).

7. Dispositif selon les revendications 5 et 6, caractérisé en ce qu'un réservoir réfrigérant (6) est monté en amont de la bande transporteuse pour les cartes imprimées (7).

8. Dispositif selon les revendications 5 à 7, caractérisé en ce qu'au moins un radiateur infrarouge (10) est installé verticalement à l'extrémité de la racle chauffante (4).

9. Dispositif selon les revendications 5 à 8, caractérisé en ce qu'une cuve de stockage (8) pouvant être refroidie et un dispositif doseur (9) sont montés en amont de la cuve chauffante (2).

10. Dispositif selon les revendications 5 à 9, caractérisé en ce que les radiateurs infrarouges (5, 10) peuvent opérer dans la gamme de températures de 160 à 220°C et que des fixations appropriées permettent d'obtenir une distance variable des radiateurs.

11. Dispositif selon la revendication 5, caractérisé en ce qu'il comporte un chariot d'enduction possédant des aspirateurs à vide qui sont montés chacun sur deux fixations équipées d'une genouillère et qui, de leur côté, sont guidées sur des rails installés en dehors du rideau de vernis.

Fig. 1

EP 0 620 930 B1

12